Europäisches Patentamt

(19) European Patent Office

Office européen des brevets

(11) Publication number: **0 109 227**

**B1**

(12) **EUROPEAN PATENT SPECIFICATION**

(45) Date of publication of patent specification: **10.02.88**

(21) Application number: **83306660.8**

(22) Date of filing: **02.11.83**

(51) Int. Cl.⁴: **G 08 B 13/14, G 01 R 19/145**

(54) **Alarm unit.**

(30) Priority: **03.11.82 GB 8231452**

(43) Date of publication of application:
**23.05.84 Bulletin 84/21**

(45) Publication of the grant of the patent:
**10.02.88 Bulletin 88/06**

(84) Designated Contracting States:
**BE DE FR NL**

(56) References cited:
**DE-A-1 274 014**
**DE-A-2 924 207**
**GB-A-2 083 236**
**US-A-3 289 194**
**US-A-3 836 901**
**US-A-4 121 201**
**US-A-4 237 450**

(73) Proprietor: **Video Alarms & Systems Company**
**Limited**
**10 Linden Close**
**Lymm Cheshire WA13 9PH (GB)**

(72) Inventor: **Webb, Alan**
**10 Linden Close**
**Lymm Cheshire (GB)**
Inventor: **Totton, Frederick Malcolm**
**1 Crossfield Avenue**
**Lymm Cheshire (GB)**
Inventor: **Fowles, Kenneth Stephen**
**72 Albany Road**
**Statham Lymm Cheshire (GB)**

(74) Representative: **Lawrence, John Gordon et al**
**McNeight & Lawrence Regent House Heaton**
**Lane**
**Stockport, Cheshire SK4 1BS (GB)**

Courier Press, Leamington Spa, England.

## Description

This invention concerns an alarm unit for protection of a current-consuming appliance such as a video recorder.

Although primarily intended to reduce the risk of theft of appliances, such as video recorders, the unit will also give warning following mains failure alerting the user to the need to reset time clocks, check the contents of a deep freezer and so on.

In US—A—4237450 there is disclosed an appliance theft alarm for mounting on or inside an electrical appliance which, when the electrical plug connecting the appliance with a wall electrical outlet is removed, will sound an audible alarm.

The electrical power cord running between the wall outlet and the appliance is sensed for the presence of an electrical voltage. With a voltage present, a relay is energised to inhibit the alarm circuit. When the voltage is removed, the relay drops out and the alarm, energised from a self-contained battery, is activated. The battery is kept charged by a built-in charger drawing current from the wall socket. A key operated contact can disable the alarm.

The activation is maintained by a latching relay so that the alarm cannot be turned off simply by restoring the mains voltage.

A similar arrangement is disclosed in US—A—3289194.

It is a disadvantage of these arrangements, however, that they require installation on or in the appliance to be protected, such installation involving physical attachment and electrical rewiring. This is a deterrent to the use of these arrangements in as much as installation requires the services of a skilled electrician, or the appliance may be hired, so that tampering with the inside is forbidden.

The present invention is based on the realisation that, to be effective, an alarm need not be attached to or in the appliance and wired in with it, it being usually sufficient to frighten the intending thief into running from the scene without stopping to enquire as to the source of the alarm sound.

Eliminating the need for installation then gives a much greater potential utilisation of the alarm if it can be very simply connected — as by simply plugging it in by the householder.

However, this renders unsuitable the methods for detecting interference with the appliance used in the prior art arrangements, which have depended on the removal of the mains voltage, since the preferred installation arrangement has the alarm plugged in to the mains and· the appliance plugged in — by its conventional mains plug — to the alarm, which has a "mains" outlet socket. Disconnection of the appliance from the alarm in this case would not set off the alarm.

The problem is solved, according to the invention, in an alarm unit for protecting an electrical appliance which is normally connected by a mains plug to a mains outlet socket, comprising an electrically operable sound generating device, rechargeable battery means for powering said sound generating device and circuit means for charging said battery means and for operating a trigger device to operate the sound generating device, in that the unit is comprised in a housing having plug means for connection to said outlet socket and socket means for receiving said appliance mains plug, and the trigger device operates the sound generating device in response to loss of current in said appliance whether brought about by disconnection of the alarm unit from the mains outlet socket or from the appliance.

The invention will be further apparent from the following description, with reference to the figures of the accompanying drawings, which show, by way of example only, two forms of alarm unit embodying the invention.

Of the drawings:—

Figure 1 shows a perspective view of an alarm unit;

Figure 2 shows a diagram of the circuit of the alarm unit of Figure 1; and

Figure 3 shows an alternative circuit diagram for the alarm unit of Figure 1.

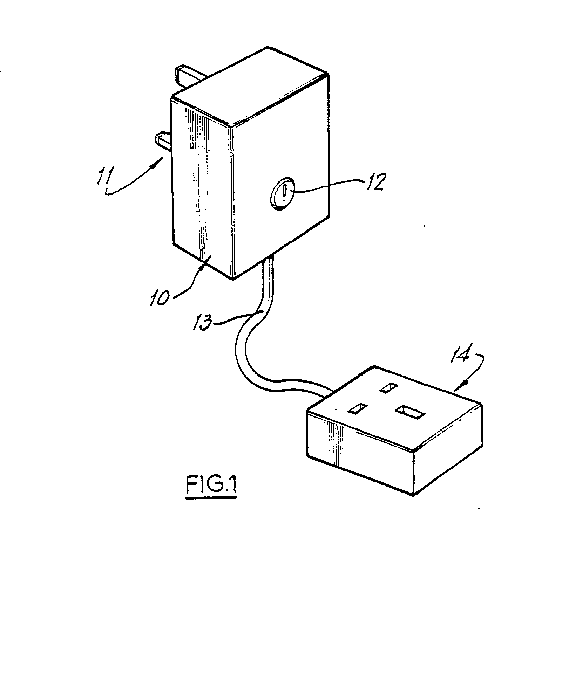

Referring first to Figure 1, it will be seen that the alarm unit comprises a housing 10 integrally formed with a three pin mains plug 11 and equipped with a key-operable switch 12 whose function will be apparent hereinafter. A lead 13 extends from the housing 10 and connects with a three pin mains socket 14 into which a video recorder to be protected is plugged.

The housing 10 contains a buzzer, a battery power supply for the buzzer and control circuitry which causes the buzzer to sound (when the unit is activated by means of the key switch 12) in the event that the video recorder ceases to draw current as will occur if it is switched off or unplugged from the socket 14 or if the alarm unit itself is unplugged from the mains or if the leads extending from the unit to the video recorder are cut.

It is a matter of experience that an alarm of this kind is a most effective deterrent against theft and it has the added advantage of providing the user with a warning in the event of mains failure to remind him to reset the time clock on his video recorder.

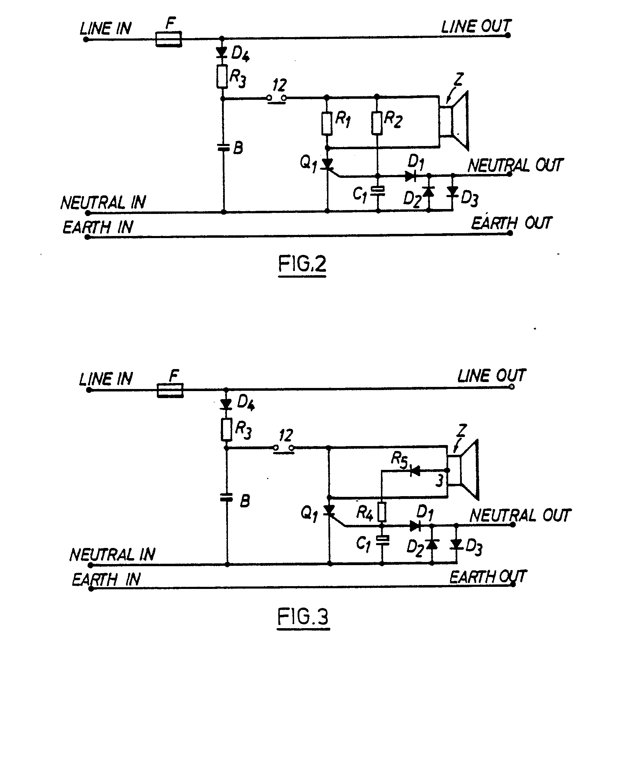

Figure 2 shows one possible circuit arrangement.

The battery B which is a rechargeable cell provides power for the circuit and the buzzer Z. A resistor $R_3$ and diode $D_4$ provide continuous trickle charge current into the battery B. The key switch 12 provides means of arming and resetting the alarm circuit.

When operative the key switch 12 is closed and current consumed by the video recorder flows from the line input through the fuse F out through the recorder and back to the neutral input through the back to back diodes $D_2$ and $D_3$. The resulting voltage drop across these diodes ($\pm 0.7$ volts square wave measured with respect to the neutral input line) provides a hold off voltage to the silicon controlled rectifier trigger device Q1 via diode $D_1$.

The absence of current through the back to back diodes removes the hold of negative voltage and the capacitor $C_1$ will begin to charge through resistor $R_2$ until the trigger on positive threshold voltage is reached. At this point the trigger circuit will function to operate the buzzer Z.

Resistor $R_1$ provides a holding current through the trigger device such that once triggered into an alarm condition, reinstatement of current through the video recorder will not disarm the alarm. The alarm will therefore continue to sound until the battery B is exhausted or until the key is inserted into the key switch 12 and the unit reset.

Short duration mains drop out such as may be caused by electrical storms or power station switch overs can be accommodated by varying the time constant afforded by components $R_2$ and $C_1$. Thus a time delay to alarm condition may be introduced to prevent the alarm sounding on short duration mains drop outs. This time constant may be set from less than 1 second to 10 seconds. A 2 seconds delay has been found adequate.

Figure 3 shows a modified circuit whereby when triggered into alarm the buzzer Z continues to sound until the battery B becomes discharged to the point where the buzzer is unable to produce sound. At this point, with the battery partially discharged, the holding voltage for the trigger device Q1 is removed and the alarm resets. By this means the battery B is not exhausted and the time required to recharge to an operating service level is considerably reduced.

The circuit functions by detecting the back EMF produced by the buzzer Z and using this voltage which is only produced when the battery is at a sufficient state of charge to sustain an acoustic output from the buzzer to hold the trigger device in the alarm on state.

The back EMF produced across the buzzer on terminal 3 is rectified by Diode D5 and applied via the resistor R4 onto the trigger device control electrode. The holding resistor $R_1$ of the first described circuit is no longer required. Thus the trigger device is held on in the alarm state only so long as the battery B is able to sustain operation of the buzzer Z. When the buzzer Z ceases to operate as the battery becomes partially discharged, the back EMF produced at terminal 3 ceases and the holding voltage produced across $C_1$ will discharge and the trigger device will reset to the off mode.

It will be appreciated that it is not intended to limit the invention to the above example only, many variations, such as might readily occur to one skilled in the art, being possible, without departing from the scope thereof as defined by the appended claims.

Thus, for example, the buzzer may be replaced by some other sound generating device.

Again, for example, the trigger device may be some other solid state circuit or even a self-latching electromechanical relay.

The socket into which the video recorder is plugged may itself be incorporated in the housing or may be replaced by a terminal block to which the video recorder may be connected.

Again, the unit may be incorporated within a flush mounted mains socket outlet or adapted for fitting within the video recorder itself.

**Claims**

1. An alarm unit adapted for protecting an electrical appliance which is normally connected by a mains plug to a mains outlet socket, comprising an electrically operable sound generating device (Z), rechargeable battery means (B) for powering said sound generating device and circuit means for charging said battery means and for operating a trigger device (Q1) to operate the sound generating device, characterised in that the unit is comprised in a housing (10) having plug means (11) for connection to said outlet socket and socket means (14) for receiving said appliance mains plug, and the trigger device (Q1) operates the said generating device (Z) in response to loss of current in said appliance whether brought about by disconnection of the alarm unit from the mains output socket or from the appliance.

2. An alarm unit according to claim 1, characterised in that the battery (B), sound generating device (2) and circuit means are located in a housing (10) formed integrally with a plug (11) adapted to be engaged with a mains outlet socket.

3. An alarm unit according to claim 2 characterised in that said socket means (14) are comprised by a mains socket (14) connected to said housing (10) by a lead (13).

4. An alarm unit according to any preceding claim, characterised by including a key operable switch (12) enabling the unit to be disarmed.

5. An alarm unit according to any preceding claim, characterised in that said trigger device (Q1) is a solid state device.

6. An alarm unit according to claim 5, characterised in that said trigger device (Q1) is a silicon controlled rectifier.

7. An alarm unit according to claim 6, characterised in that said silicon controlled rectifier (Q1) is held off by a negative voltage appearing across back to back diodes (D2, D3) through which current is drawn by said appliance.

8. An alarm unit according to any preceding claim, characterised by including means (D5, D4) for switching the trigger device (Q1) off to prevent battery (B) discharge when the battery can no longer power the sound generating device (2).

9. An alarm unit according to any preceding claim, characterised in that the sound generating device comprises a buzzer.

**Patentansprüche**

1. Alarmeinheit für den Schutz eines elektrischen Gerätes, das normalerweise über einen Netzstecker mit einer Netzsteckdose verbunden ist, mit einer elektrisch betreibbaren Schallerzeugungsvorrichtung (Z), einer wiederaufladbaren Batterie (B) zur Speisung der Schallerzeugungsvorrichtung und Schaltungselementen zur Aufladung der Batterie und zum Betreiben einer Auslösevorrichtung (Q1) für den Betrieb der Schallerzeugungsvorrichtung, dadurch gekennzeichnet, daß die Einheit in einem Gehäuse (10) mit einem Stecker (11) für die Verbindung zur Netzsteckdose enthalten und eine Steckdose (14) zur Aufnahme des Gerätenetzsteckers vorgesehen sind, und die Auslösevorrichtung (Q1) die Erzeugungsvorrichtung (Z) in Abhängigkeit von einem Stromausfall im Gerät betreibt, der durch eine Trennung der Alarmeinheit von der Netzsteckdose oder vom Gerät bewirkt wurde.

2. Alarmeinheit nach Anspruch 1, dadurch gekennzeichnet, daß die Batterie (B), die Schallerzeugungsvorrichtung (2) und die Schaltungselemente in einem Gehäuse (10) angeordnet sind, das integral mit einem zur Verbindung mit einer Netzsteckdose geeigneten Stecker (11) ausgebildet ist.

3. Alarmeinheit nach Anspruch 2, dadurch gekennzeichnet, daß die Steckdose (14) von einer Netzsteckdose (14) dargestellt ist, die durch eine Leitung (13) mit dem Gehäuse (10) verbunden ist.

4. Alarmeinheit nach einem der vorhergehenden Ansprüche, gekennzeichnet durch einen schlüsselbetätigbaren Schalter (12), durch den die Einheit unwirksam gemacht werden kann.

5. Alarmeinheit nach einem der vorhergehenden Ansprüche, dadurch gekennzeichnet, daß die Auslösevorrichtung (Q1) eine Festkörperanordnung ist.

6. Alarmeinheit nach Anspruch 5, dadurch gekennzeichnet, daß die Auslösevorrichtung (Q1) ein siliziumgesteuerter Gleichrichter ist.

7. Alarmeinheit nach Anspruch 6, dadurch gekennzeichnet, daß der siliziumgesteuerte Gleichrichter (Q1) durch eine negative Spannung ausgeschaltet ist, die über parallelen, gegensinnig gepolten Dioden (D2, D3) auftritt, über die der vom Gerät benötigte Strom fließt.

8. Alarmeinheit nach einem der vorangehenden Ansprüche, dadurch gekennzeichnet, daß eine Vorrichtung (D5, D4) zur Abschaltung der Auslösevorrichtung (Q1) vorgesehen ist, um eine Entladung der Batterie (B) zu verhindern, wenn diese die Schallerzeugungsvorrichtung (2) nicht länger betreiben kann.

9. Alarmeinheit nach einem der vorangehenden Ansprüche, dadurch gekennzeichnet, daß die Schallerzeugungsvorrichtung einen Summer aufweist.

**Revendications**

1. Dispositif d'alarme conçu pour protéger un appareil électrique qui est normalement connecté par une prise mâle de courant du secteur à une prise femelle de courant du secteur, comprenant un dispositif (Z) générateur de son électriquement actionnable, une batterie rechargeable (B) servant à électriquement alimenter le dispositif générateur de son et un circuit permettant de charger ladite batterie et d'actionner un dispositif de déclenchement (Q1) afin de faire fonctionner le dispositif générateur de son, caractérisé en ce que le dispositif est compris dans un boîtier (10) possédant une prise mâle (11) destinée à être connectée à ladite prise femelle et une prise femelle (14) destinée à recevoir ladite prise mâle de l'appareil, et en ce que le dispositif de déclenchement (Q1) fait fonctionner ledit dispositif générateur (Z) en réaction à une disparition du courant dans ledit appareil qui est amenée par une déconnexion du dispositif d'alarme vis-à-vis de la prise femelle d'alimentation en courant du secteur ou bien vis-à-vis de l'appareil.

2. Dispositif d'alarme selon la revendication 1, caractérisé en ce que la batterie (B), le dispositif générateur de son (2) et ledit circuit sont placés dans un boîtier (10) solidairement doté d'une prise mâle (11) destinée à être engagée dans une prise femelle d'alimentation en courant du secteur.

3. Dispositif d'alarme selon la revendication 2, caractérisé en ce que ladite prise femelle (14) du dispositif est constituée par une prise femelle d'alimentation en courant du secteur (14) connectée audit boîtier par un fil conducteur (13).

4. Dispositif d'alarme selon l'une quelconque des revendications précédentes, caractérisé en ce qu'il comporte un commutateur (12) actionnable par clé permettant de désarmer l'unité.

5. Dispositif d'alarme selon l'une quelconque des revendications précédentes, caractérisé en ce que ledit dispositif de déclenchement (1) est un dispositif du type état solide.

6. Dispositif d'alarme selon la revendication 5, caractérisé en ce que ledit dispositif de déclenchement (Q1) est un redresseur commandé au silicium.

7. Dispositif d'alarme selon la revendication 6, caractérisé en ce que ledit redresseur commandé au silicium (Q1) est maintenu non conducteur par une tension négative apparaissant entre les diodes (D2, D3) mises dos à dos à travers lesquelles du courant est tiré par ledit appareil.

8. Dispositif d'alarme selon l'une quelconque des revendications précédentes, caractérisée en ce qu'elle comporte un moyen (D5, D4) permettant de commuter le dispositif de déclenchement (Q1) dans l'état non conducteur afin d'empêcher la batterie (B) de se décharger lorsque la batterie ne peut plus alimenter en énergie électrique le dispositif générateur de son (2).

9. Dispositif d'alarme selon l'une quelconque des revendications précédentes, caractérisé en ce que le dispositif générateur de son comprend une sirène du type vibreur.

0 109 227

FIG.1

LINE IN  F  LINE OUT

D₄

R₃  12  Z

R₁  R₂

B

Q₁  D₁  NEUTRAL OUT

C₁  D₂  D₃

NEUTRAL IN

EARTH IN  EARTH OUT

FIG.2

LINE IN  F  LINE OUT

D₄

R₃  12  Z

R₅  3

B

Q₁  R₄  D₁  NEUTRAL OUT

C₁  D₂  D₃

NEUTRAL IN

EARTH IN  EARTH OUT

FIG.3